# EUROPÄISCHE PATENTSCHRIFT

(11) **EP 3 819 653 B1**
(45) Veröffentlichungstag und Bekanntmachung des Hinweises auf die Patenterteilung: **06.09.2023**
(21) Anmeldenummer: 19207566.1
(22) Anmeldetag: 07.11.2019
(51) Int. Cl.: G01R 33/36

(54) **VERFAHREN ZUM PRÜFEN EINER EMPFANGSKETTE EINES MAGNETRESONANZTOMOGRAPHEN**
METHOD FOR TESTING A RECEIVE CHAIN OF A MAGNETIC RESONANCE TOMOGRAPH
PROCÉDÉ D'ESSAI D'UNE CHAÎNE DE RÉCEPTION D'UN TOMOGRAPHE À RÉSONANCE MAGNÉTIQUE

(43) Veröffentlichungstag der Anmeldung: 12.05.2021
(73) Patentinhaber: Siemens Healthcare GmbH, 91052 Erlangen (DE)
(72) Erfinder: Biber, Stephan, 91056 Erlangen (DE)

(56) Entgegenhaltungen:
- EP-A1- 1 664 820
- DE-A1-102015 211 023
- DE-T2- 68 918 048
- US-A1- 2015 185 307
- PASCAL P STANG ET AL: "Medusa: A Scalable MR Console Using USB", IEEE TRANSACTIONS ON MEDICAL IMAGING, IEEE SERVICE CENTER, PISCATAWAY, NJ, US, Bd. 31, Nr. 2, 1. Februar 2012 (2012-02-01), Seiten 370-379, XP011401517, ISSN: 0278-0062, DOI: 10.1109/TMI.2011.2169681
- Anonymous: "Application Note, IMD Measurements Using Dual Source and Multiple Source Control, MS4640B Series Vector Network Analyzer", , 27. Mai 2015 (2015-05-27), XP055689658, Gefunden im Internet: URL:https://dl.cdn-anritsu.com/en-us/test- measurement/files/Application-Notes/Applic ation-Note/11410-00816C.pdf [gefunden am 2020-04-28]

## Beschreibung

Die Erfindung betrifft ein Verfahren zum Betrieb eines Magnetresonanztomographen, mit dem eine ordnungsgemäße Funktion eines Empfangsweges des Magnetresonanztomographen geprüft werden kann.

Magnetresonanztomographen sind bildgebende Vorrichtungen, die zur Abbildung eines Untersuchungsobjektes Kernspins des Untersuchungsobjektes mit einem starken äußeren Magnetfeld ausrichten und durch ein magnetisches Wechselfeld zur Präzession um diese Ausrichtung anregen. Die Präzession bzw. Rückkehr der Spins aus diesem angeregten in einen Zustand mit geringerer Energie wiederum erzeugt als Antwort ein magnetisches Wechselfeld, das über Antennen empfangen wird.

Mit Hilfe von magnetischen Gradientenfeldern wird den Signalen eine Ortskodierung aufgeprägt, die nachfolgend eine Zuordnung von dem empfangenen Signal zu einem Volumenelement ermöglicht. Das empfangene Signal wird dann ausgewertet und eine dreidimensionale bildgebende Darstellung des Untersuchungsobjektes bereitgestellt. Zum Empfang des Signals werden vorzugsweise lokale Empfangsantennen, sogenannte Lokalspulen verwendet, die zur Erzielung eines besseren Signal-Rauschabstandes unmittelbar am Untersuchungsobjekt angeordnet werden. Die Empfangsantennen können auch in einer Patientenliege verbaut sein.

Die Bildqualität ist wegen der sehr schwachen Magnetresonanzsignale empfindlich von einer ordnungsgemäßen Funktion eines Empfangspfades von der Antenne bis zur Digitalisierung und Auswertung abhängig. Selbst geringe Verschlechterungen, wie sie durch erhöhten Übergangswiderstand an Steckverbindungen oder durch Degradation von Bauelementen schleichend auftreten können, führen zu einer reduzierten Bildqualität und erhöhtem Zeitaufwand bei der Bilderfassung.

Aus dem Dokument DE 68918048 T2 ist ein Kernspinresonanzverfahren bekannt, mit dem ein Objekt, das sich in einem statischen homogenen Magnetfeld befindet, mit Hochfrequenzelektromagnetimpulsen zum Erhalten von Kernspinresonanzsignalen angestrahlt wird, die mit Empfangsmitteln empfangen und demoduliert werden, wonach die demodulierten Resonanzsignale zum Erhalten von Abtastwerten abgetastet werden und aus den Abtastwerten eine Kernspinresonanzverteilung bestimmt wird.

Nichtlineare Verzerrung der Resonanzsignale durch Verzerrung in den Empfangsmitteln, die an sich eine nahezu lineare Übertragungsfunktion aufweisen, durch Verzerrung der abgetasteten Resonanzsignale, werden mit Hilfe einer Gegenverzerrungsfunktion ausgeglichen, die für die nichtlineare Verzerrung gegenverzerrend wirkt.

Das Dokument EP 1 664 820 A1 beschreibt eine dynamische Anpassung der Empfängerempfindlichkeit während einer Magnetresonanzaufnahme. Um Amplituden- oder Phasenverzerrungen Q zu erkennen, die von einem Empfänger verursacht werden und nicht notwendigerweise bei unterschiedlichen Empfindlichkeitseinstellungen identisch sind, wird ein Referenzhochfrequenzsignal durch eine zusätzliche Antenne dem Empfangsweg beigefügt. Vorzugsweise ist das Referenzsignal so eingestellt, dass seine Frequenz am Rand des von dem Magnetresonanztomographen erfassten Frequenzbandes M liegt. Ein Vergleich der vorab bekannten Amplitude und Phase des Referenzsignals mit der Amplitude und Phase des empfangenen Referenzsignals erlaubt es, die Verzerrungen zu bestimmen, die mit der eingestellten Empfindlichkeit eingeführt werden und nachfolgend zu beseitigen.

Aus dem Dokument US 2015/185307 A1 ist ein Verfahren und eine Vorrichtung zur Korrektur eines Magnetresonanzsignals bekannt. Das Verfahren umfasst das Empfangen eines Magnetresonanzsignales mit einem Hochfrequenzempfangskanal und Korrektur des Magnetresonanzsignals mit einer Signalabbildungsfunktion des Hochfrequenzempfangskanals.

Das Dokument PASCAL P STANG ET AL: "Medusa: A Scalable MR Console Using USB", IEEE TRANSACTIONS ON MEDICAL IMAGING, IEEE SERVICE CENTER, PISCATAWAY, NJ, US, Bd. 31, Nr. 2, 1. Februar 2012 (2012-02-01), Seiten 370-379, XP011401517, ISSN: 0278-0062, DOI: 10.1109/TMI.2011.2169681 schlägt eine offene Systemarchitektur "Medusa" unter Verwendung eines USB-Busses zur Skalierung vor, kombiniert mit verteiltem Pufferspeicher und Rechenleistung, um die hohen Datenraten und strengen Synchronitätsanforderungen eines Vielkanal-Magnetresonanztomographen zu adressieren. Medusa verwendet ein modulares Konzept, das auf digitalen Sythesizern, Empfängern, Gradientensteuerungen in Verbindung mit einer schnellen programmierbaren Logik zum Abtasten und Synchronisieren beruht.

Das Dokument Anonymous: "Application Note, IMD Measurements Using Dual Source and Multiple Source Control, MS4640B Series Vector Network Analyzer" diskutiert Abwägungen zur Messung und liefert ein Beispiel, wie man mit einem Anritsu VectorStar MS4640B Serie Vektor-Netzwerk-Analysegerät Zweitonmessungen mit fester Frequenz und Intermodulations-Verzerrungsmessungen (IMD) mit veränderlicher Frequenz ausführt. Ein besonderer Schwerpunkt liegt auf der Messung von Intermodulationsprodukten dritter Ordnung und den Berechnungen zur Bestimmung des 3-Ordnung-Schnittpunkts (TOI oder IP3) .

Aus dem Dokument DE 10 2015 211023 A1 ist eine Lokalspule mit einer Prüfeinrichtung für einen Magnetresonanztomographen sowie ein System aus Magnetresonanztomograph und Lokalspule sowie ein Verfahren zum Betrieb bekannt. Die Lokalspule weist einen ersten Anschluss zur Verbindung mit dem Magnetresonanztomographen und eine Prüfeinrichtung zur Prüfung eines Systems aus der Lokalspule und des damit verbundenen Magnetresonanztomographen auf. Die Prüfeinrichtung ist ausgelegt, ein Prüfsignal in der Lokalspule zu erfassen.

Es ist daher eine Aufgabe der Erfindung, das Erkennen derartiger Degradationen zu erleichtern.

Die Aufgabe wird durch ein erfindungsgemäßes Verfahren nach Anspruch 1 gelöst.

Der Magnetresonanztomograph weist einen Empfänger und einen Sender auf. Der Sender ist ausgelegt, ein erstes Zweitonsignal mit einer ersten Frequenz f1 und einer zweiten Frequenz f2 zu erzeugen und auszugeben, wobei die erste Frequenz f1 ungleich der zweiten Frequenz f2 ist.

Der Frequenzabstand ist dabei mindestens so groß, dass die Signalanteile bei f1 und f2 von dem Empfänger getrennt werden können, also zwischen der Amplitude bei f1 und der Amplitude bei f2 ein relatives Amplitudenminimum liegt. Der Frequenzabstand kann beispielsweise größer 100 Hz, 1 kHz, 10 kHz oder 100 kHz sein. Die erste Frequenz f1, die zweite Frequenz f2 und ein Intermodulationsprodukt 3. Ordnung (IM3) oder höherer Ordnung der ersten Frequenz f1 und der zweiten Frequenz f2 liegen in einem gemeinsamen Empfangsbereich des Empfängers, vorzugsweise bei einer Larmorfrequenz des Magnetresonanztomographen, die durch eine statische Magnetfeldstärke B0 und das magnetische Moment der zu untersuchenden Kernspins vorgegeben ist. Insbesondere Intermodulationsprodukte ungerader Ordnung, beispielsweise 3. Ordnung 5. Ordnung oder allgemein (2n+1)ter Ordnung mit n als natürlicher Zahl größer gleich 1, können dabei mit ihrer Frequenz jeweils nahe bei den Ursprungsfrequenzen f1 und f2 liegen, jedoch mit schnell mit der Ordnung abnehmender Amplitude. Der Empfangsbereich kann dabei beispielsweise bis zu 1kHz, 10 kHz, 100 kHz, 1 MHz oder 5 MHz breit sein, wobei die Breite durch eine Dämpfung größer 6 dB, 12 dB oder mehr außerhalb des Bereichs definiert ist. Dabei ist es auch denkbar, dass das Empfangssignal durch Mischen oder digitale Signalverarbeitung in der Frequenz umgesetzt wird. Als im Empfangsbereich des Empfängers liegend wird es entsprechend auch der Erfindung angesehen, wenn Signale mit ursprünglichen Frequenzen f1, f2 und der Frequenz des Intermodulationsproduktes nach Frequenzumsetzung von dem Empfänger aufgenommen und ausgewertet werden können.

Ein Pegel des ausgegebenen Zweitonsignals liegt dabei in einem Pegelbereich, bei dem das empfangene Zweitonsignal am Empfänger als obere Grenze immer noch im Linearbereich des Empfängers liegt. Der Linearbereich kann dabei der Bereich mit einer maximalen Kompression der Kennlinie kleiner als 0,1 dB oder 1 dB angesehen werden. Als unterer Grenze des Pegelbereichs wir dabei der Pegel eines Eigenrauschens des Empfängers angesehen bzw. ein Signalabstand des IM3 zu diesem Rauschpegel von 3 dB, 6 dB oder mehr.

Das Ausgeben des Signals durch den Sender kann dabei zum einen das Aussenden über eine Antenne, beispielsweise eine Körperspule, oder auch über eine andere elektrische oder magnetische Antenne als elektromagnetisches Wechselfeld sein. Zum anderen ist es aber zur Diagnose auch denkbar, wie in den Unteransprüchen näher ausgeführt, dass das Ausgangssignal über eine Signalschleife an unterschiedlichen Diagnosepunkten direkt eingekoppelt wird, beispielsweise galvanisch, induktiv oder kapazitiv. Die am Einspeisepunkt erforderlichen Pegel der Zweitonsignale hängen dann jeweils von der Verstärkung bzw. Dämpfung auf der Signalstrecke zwischen Einspeisepunkt und Empfänger ab.

Der Sender kann dabei der Sender des Magnetresonanztomographen zur Anregung der Kernspins sein, sofern sich dessen Ausgangspegel ausreichend reduzieren lässt. Erforderlich ist eine ausreichende Linearität auch im unteren Leistungsbereich. Denkbar ist es auch, dass das erforderliche Kleinsignal direkt aus dem Eingangssignal der Endstufe unter Umgehung der Endstufe erzeugt wird. Möglich wäre es aber auch, einen eigenen Sender zur Erzeugung der Zweitonsignale bereitzustellen oder anstelle der Leistungsendstufe einen linearen Kleinsignalverstärker im Sender zu vorzusehen.

Der Magnetresonanztomograph ist ausgelegt, ein zweites Zweitonsignal auszusenden, das sich im Pegel von dem ersten Zweitonsignal unterscheidet.

Das erfindungsgemäße Verfahren ist zur Funktionsprüfung einer Empfangskette des Magnetresonanztomographen vorgesehen.

Die Empfangskette kann dabei alle Elemente im Signalpfad von der Antenne, beispielsweise Lokalspule oder Körperspule, bis hin zur Digitalisierung im Empfänger und der nachgeordneten Bildrekonstruktion umfassen. Es ist aber auch denkbar, dass lediglich Teile davon geprüft werden, beispielsweise um einen Fehler näher zu lokalisieren.

In einem Schritt des Verfahrens gibt der Sender, gesteuert von einer Steuerung des Magnetresonanztomographen, ein erstes Zweitonsignals mit einem ersten Pegel aus. Das Ausgeben kann dabei, wie bereits zum Magnetresonanztomographen dargelegt, ein Aussenden über eine Antenne oder beispielsweise auch ein Einkoppeln über eine Signalschleife in einen Diagnosepunkt eines Empfangspfades sein. Der Pegel des ersten Zweitonsignals ist dabei so vorbestimmt, dass er zumindest über einem Rauschpegel des Empfängers liegt, wenn es den Signalweg bis zum Empfänger bzw. der Analyseeinrichtung durchlaufen hat.

In einem weiteren Schritt erfasst eine Analyseeinrichtung ein erstes Intermodulationsprodukt über die Signalschleife. In einer bevorzugten Ausführungsform wird dabei die Analyseeinrichtung durch Komponenten des Magnetresonanztomographen bereitgestellt, beispielsweise einen Empfänger für die Magnetresonanzsignale zur Aufbereitung der Hochfrequenz und die nachfolgende Signalverarbeitung der Bildrekonstruktion zur Auswertung durch z.B. eine Fouriertransformation. Die Signalschleife kann dabei alle Komponenten des Empfangsweges von einer Antennenspule bis zum Empfänger umfassen, oder auch nur Teile von einem Diagnosepunkt auf dem Empfangsweg bis zum Empfänger, um einen Fehler näher zu lokalisieren. Denkbar ist es aber auch, dass eine Hochfrequenzaufbereitung und Signalanalyse in einer separaten Analyseeinrichtung erfolgt. In einer denkbaren Ausführungsform werden insbesondere Amplituden des IM3 und bei f1 und f2 erfasst.

In einem weiteren Schritt gibt der Sender ein zweites Zweitonsignal mit einem zweiten Pegel aus. Das zweite Zweitonsignal unterscheidet sich dabei im Pegel von dem ersten Zweitonsignal. Beispielsweise kann es einen um mindestens 3 dB, 6 dB, 12 dB größeren Pegel aufweisen oder auch höher, solange die Bedingung des Linearbereichs, wie er zuvor definiert wurde, erfüllt ist. Auch erfolgt die Pegeländerung vorteilshafterweise für beide Frequenzen f1 und f2 des Zweitonsignals in die gleiche Richtung, damit sich eine Änderung in dem Intermodulationssignal ungerader, insbesondere dritter Ordnung nicht teilweise kompensiert.

In einem weiteren Schritt erfasst die Analyseeinrichtung ein zweites Intermodulationsproduktes über die Signalschleife. Hierzu gilt das bereits zum Erfassen des ersten Zweitonsignal dargelegte.

Grundsätzlich ist die Reihenfolge von erstem und zweitem Zweitonsignal austauschbar, d.h. ob zunächst mit höherem Pegel gesendet wird oder niedrigerem, ändert lediglich das nachfolgende Ermitteln geringfügig.

In einem weiteren Schritt wird eine Prüfwert in Abhängigkeit von dem Pegel des ersten Zweitonsignals, dem Pegel des zweiten Zweitonsignals, einem Pegel des ersten Intermodulationsproduktes und einem Pegel des zweiten Intermodulationsproduktes ermittelt. Mögliche Ausführungsformen sind nachfolgend zu den Unteransprüchen angeführt. Durch Zweitonsignale mit unterschiedlichem Pegel ist es auf vorteilhafte Weise dabei möglich, einen Einfluss einer über beide Messungen konstanten Dämpfung z.B. durch Einkoppelglieder, insbesondere bei einer Messung über eine Antennenspule einer Lokalspule durch die räumliche Anordnung, zu eliminieren und einen davon unabhängigen Prüfwert zu ermitteln. Ist die Dämpfung jedoch bekannt, würde grundsätzlich auch eine einzelne Messung mit einem Zweitonsignal ausreichen, um einen Prüfwert zu ermitteln, dies ist jedoch nicht Teil der beanspruchten Erfindung.

Mehrere Messungen könnten dann genützt werden, um beispielsweise Rauschen zu reduzieren oder andere pegelabhängige Parameter zu eliminieren.

In einem weiteren Schritt vergleicht die Analyseeinrichtung den ermittelten Prüfwert mit einem vorbestimmten Referenzwert. Der vorbestimmte Prüfwert kann beispielsweise durch eine Referenzmessung bei Inbetriebnahme, im Labor oder auch aus Simulationen ermittelt werden. Der Vergleich kann auch durch die Steuerung des Magnetresonanztomographen erfolgen, sodass dies Teil der Analyseeinrichtung ist.

In einem anderen Schritt wird ein Signal an einen Bediener auf einem Ausgabegerät ausgegeben oder ein Signal an eine Steuerung des Magnetresonanztomographen in Abhängigkeit von dem Vergleich. Wenn das Signal eine Abweichung von Referenzwert aufzeigt, die zu einer Bildverschlechterung führt, kann dann die Steuerung oder der Bediener eine Bilderfassung unterbrechen. Es kann auch eine Servicemaßnahme veranlasst werden, um den Fehler zu beheben. Denkbar ist es auch, dass die Steuerung die Schritte des Verfahrens mit einer veränderten Signalschleife wiederholt, wie zu den nachfolgenden Unteransprüchen erläutert wird.

Auf vorteilhafte Weise ermöglicht ein Magnetresonanztomograph mit einem Sender mit Zweitonsignal mit dem erfindungsgemäßen Verfahren durch das auf Veränderungen sensitive Intermodulationsprodukt ungerader, insbesondere dritter Ordnung, Verschlechterungen in der Empfangskette frühzeitig zu erkennen. Dabei erlauben es die unterschiedlichen Pegel, Variationen im Pegel z.B. beim Einkoppeln, in der Auswertung zu eliminieren.

Weitere vorteilhafte Ausführungsformen sind zu den Unteransprüchen angegeben.

Der Magnetresonanztomograph weist eine Analyseeinrichtung auf. Die Analyseeinrichtung ist ausgelegt, einen Pegel des Intermodulationsproduktes in einem Eingangssignal zu bestimmen. Die Analyseeinrichtung kann beispielsweise Teil der Bildrekonstruktion sein. Denkbar ist aber auch ein dedizierter Signalprozessor oder eine Signalverarbeitungskomponente des Empfängers. Der Pegel des Intermodulationsproduktes kann z.B. durch einen analogen oder digitalen Filter und anschließende Amplitudenmessung oder direkt mittels Fouriertransformation des digitalisierten Signals erfolgen.

Durch das Intermodulationsprodukt ist auf vorteilhafte Weise eine besonders sensitive Erkennung von Abweichungen in der Empfangskette möglich.

Der Magnetresonanztomograph weist eine Signalschleife auf. Die Signalschleife ist ausgelegt, das Zweitonsignal des Senders in eine Komponente eines Empfangsweges des Empfängers einzukoppeln. Als Signalschleife wird dabei jede Signalverbindung angesehen, die ein vom Sender ausgegebenes Zweitonsignal über eine oder mehrere Komponenten eines Empfangsweges des Magnetresonanztomographen zu dem Empfänger, insbesondere dem Empfänger für Magnetresonanzsignale, zu leiten, einschließlich der darin enthaltenen Signalverarbeitungsschritte.

Auf vorteilhafte Weise ist es über die Signalschleife möglich, das Zweitonsignal als Testsignal in den Empfangspfad des Magnetresonanztomographen einzukoppeln.

In einer denkbaren Ausführungsform weist Magnetresonanztomograph eine Lokalspule auf. Die Signalschleife umfasst die Lokalspule, mit anderen Worten, das Zweitonsignal wird in die Lokalspule eingekoppelt und durchläuft den Empfangspfad bis zum Empfänger. In einer Ausführungsform schließt die Signalschleife dabei eine Antennenspule der Lokalspule ein, d.h. das Zweitonsignal wird in die Antennenspule induktiv eingekoppelt. Es ist aber auch denkbar, dass die Lokalspule einen Diagnoseanschluss zum Anschluss an die Signalschleife aufweist, sodass ein Diagnosesignal direkt elektrisch eingekoppelt werden kann. In einer Ausführungsform kann das Zweitonsignal auch optisch eingekoppelt und durch einen fotoelektrischen Wandler in ein elektrisches Signal umgesetzt wird.

Auf vorteilhafte Weise erlaubt es der Magnetresonanztomograph auch die Funktion der Lokalspule zu prüfen.

In einer möglichen Ausführungsform weist der Magnetresonanztomograph eine Signalweiche in dem Signalpfad auf. Die Signalweiche kann beispielsweise durch einen oder mehrere elektronische oder mechanische Schalter ausgeführt sein, die auch in einer Matrix verschaltet sein können. Die Signalweiche weist zumindest einen Signaleingang für das Zweitonsignal auf und mindestens zwei Signalausgänge, die durch die Steuerung mit dem Signaleingang verbindbar sind. Eine Steuerung des Magnetresonanztomographen ist ausgelegt, das Zweitonsignal des Senders mittels der Signalweiche in unterschiedliche Komponenten des Empfangsweges einzukoppeln. Beispielsweise können die Signalausgänge der Signalweiche direkt mit der Lokalspule und einem Anschluss der Lokalspule an den Empfänger verbunden sein. Die Signalweiche ermöglicht durch Einspeisen des Zweitonsignals einmal in die Lokalspule und einmal direkt in den Empfänger, einen Fehler in der Lokalspule zu lokalisieren.

Auf vorteilhafte Weise erlaubt es die Signalweiche, Fehler auf einzelne Abschnitte des Empfangspfades zu lokalisieren.

In einer denkbaren Ausführungsform des erfindungsgemäßen Verfahrens weist der Schritt des Ermittelns eines Prüfwertes das Bestimmen eines OIP3 (Output Intermodulation Intercept Point 3) umfasst. Der OIP3 ist dabei ein virtueller Punkt in einer doppelt logarithmischen Verstärkerkennlinie, bei der das Intermodulationsprodukt 3. Ordnung zweier Signale eine Zweitonsignals in der Amplitude gleich den Grundsignalen des Zweitonsignales würde. Der OIP3 lässt sich aus den Werten für erfasste Amplituden zweier Zweitonsignale unterschiedlichen Pegels und der Amplituden der dadurch erzeugten Intermodulationsproduktes 3. Ordnung interpolieren.

Auf vorteilhafte Weise ist der OIP3 unabhängig von der genauen Koppelstärke des Senders in die Empfangsschleife und gleichzeitig sensitiv auf Veränderungen im Empfangspfad, sodass Veränderungen und Fehler gut erkannt werden können.

In einer möglichen Ausführungsform des erfindungsgemäßen Verfahrens weist der Magnetresonanztomograph eine Signalweiche auf, wobei vor dem Schritt des Ausgebens eines Zweitonsignals der Schritt des Einstellens der Signalweiche durch die Steuerung erfolgt. Durch das Einstellen der Signalweiche wird ein Ausgang der Signalweiche mit einer Komponente des Empfangspfades gekoppelt und so eine Signalschleife von dem Sender über die Signalweiche zu dem Empfänger hergestellt, sodass ein Zweitonsignal bis zu dem Empfänger gelangen und dort ausgewertet werden kann.

Auf vorteilhafte Weise kann durch die Signalweiche die Signalschleife über unterschiedliche Komponenten geschlossen werden und so ein möglicher Fehler durch Wiederholen des Verfahrens mit unterschiedlichen Signalschleifen eingegrenzt werden.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden.

Es zeigen:
- Fig. 1: eine schematische Darstellung eines Magnetresonanztomographen zur Verwendung in einem erfindungsgemäßen Verfahren;
- Fig. 2: eine schematische Darstellung von Frequenzen beispielhafter Signale, die in dem erfindungsgemäßen Verfahren genutzt werden;
- Fig. 3: eine schematische Darstellung von Pegeln der bei dem Verfahren verwendeten Signale sowie eine mögliche Auswertung;
- Fig. 4: eine schematische Darstellung von an dem erfindungsgemäßen Verfahren beteiligten Einrichtungen einer Ausführungsform des Magnetresonanztomographen;
- Fig. 5: eine schematische Darstellung von an dem erfindungsgemäßen Verfahren beteiligten Einrichtungen einer Ausführungsform des Magnetresonanztomographen;
- Fig. 6: eine schematische Darstellung eines bei dem erfindungsgemäßen Verfahren verwendeten Senders;
- Fig. 7: eine schematische Darstellung eines bei dem erfindungsgemäßen Verfahren verwendeten Empfängers;
- Fig. 8: ein schematisches Ablaufdiagramm für ein beispielhaftes erfindungsgemäßes Verfahren.

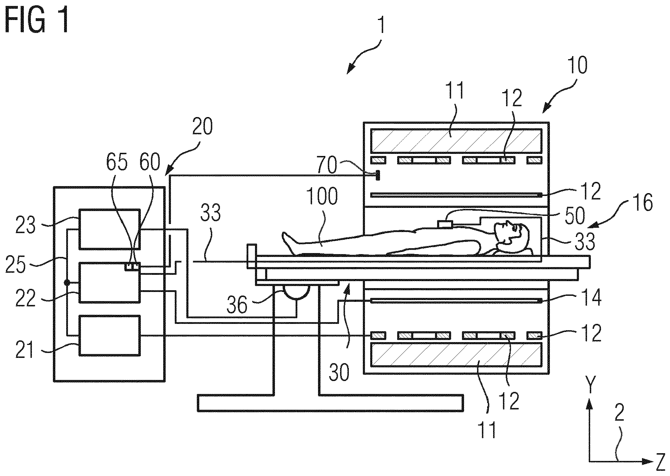

Fig. 1 zeigt eine schematische Darstellung einer Ausführungsform eines Magnetresonanztomographen 1 zur Verwendung in einem erfindungsgemäßen Verfahren.

Die Magneteinheit 10 weist einen Feldmagneten 11 auf, der ein statisches Magnetfeld B0 zur Ausrichtung von Kernspins von Proben bzw. des Patienten 100 in einem Aufnahmebereich erzeugt. Der Aufnahmebereich zeichnet sich durch ein äußerst homogenes statisches Magnetfeld B0 aus, wobei die Homogenität insbesondere die Magnetfeldstärke bzw. den Betrag betrifft. Der Aufnahmebereich ist nahezu kugelförmig und in einem Patiententunnel 16 angeordnet, der sich in einer Längsrichtung 2 durch die Magneteinheit 10 erstreckt. Eine Patientenliege 30 ist in dem Patiententunnel 16 von der Verfahreinheit 36 bewegbar. Üblicherweise handelt es sich bei dem Feldmagneten 11 um einen supraleitenden Magneten, der magnetische Felder mit einer magnetischen Flussdichte von bis zu 3T, bei neuesten Geräten sogar darüber, bereitstellen kann. Für geringere Feldstärken können jedoch auch Permanentmagnete oder Elektromagnete mit normalleitenden Spulen Verwendung finden.

Weiterhin weist die Magneteinheit 10 Gradientenspulen 12 auf, die dazu ausgelegt sind, zur räumlichen Differenzierung der erfassten Abbildungsbereiche in dem Untersuchungsvolumen dem Magnetfeld B0 variable Magnetfelder in drei Raumrichtungen zu überlagern. Die Gradientenspulen 12 sind üblicherweise Spulen aus normalleitenden Drähten, die zueinander orthogonale Felder in dem Untersuchungsvolumen erzeugen können.

Die Magneteinheit 10 weist ebenfalls eine Körperspule 14 auf, die dazu ausgelegt ist, ein über eine Signalleitung zugeführtes Hochfrequenzsignal in das Untersuchungsvolumen abzustrahlen und von dem Patient 100 emittierte Resonanzsignale zu empfangen und über eine Signalleitung abzugeben.

Eine Steuereinheit 20 versorgt die Magneteinheit 10 mit den verschiedenen Signalen für die Gradientenspulen 12 und die Körperspule 14 und wertet die empfangenen Signale aus.

So weist die Steuereinheit 20 eine Gradientenansteuerung 21 auf, die dazu ausgelegt ist, die Gradientenspulen 12 über Zuleitungen mit variablen Strömen zu versorgen, welche zeitlich koordiniert die erwünschten Gradientenfelder in dem Untersuchungsvolumen bereitstellen.

Weiterhin weist die Steuereinheit 20 eine Hochfrequenzeinheit 22 auf, die ausgelegt ist, einen Hochfrequenz-Puls mit einem vorgegebenen zeitlichen Verlauf, Amplitude und spektraler Leistungsverteilung zur Anregung einer Magnetresonanz der Kernspins in dem Patienten 100 zu erzeugen. Dabei können Pulsleistungen im Bereich von Kilowatt erreicht werden. Die Anregungspulse können über die Körperspule 14 oder auch über eine lokale Sendeantenne in den Patienten 100 abgestrahlt werden.

Eine Steuerung 23 kommuniziert über einen Signalbus 25 mit der Gradientensteuerung 21 und der Hochfrequenzeinheit 22.

Auf dem Patienten 100 ist eine Lokalspule 50 angeordnet, die über eine Anschlussleitung 33 mit der Hochfrequenzeinheit 22 und deren Empfänger 65 verbunden ist.

Die Ergebnisse einer Magnetresonanztomographie hängen wegen der schwachen Magnetresonanzsignale stark von der Empfangsqualität ab, insbesondere von dem Signal-zu-Rausch-Verhältnis ("signal to noise ratio", SNR). Das SNR kann dabei durch Bauelementdegradation schleichend verschlechtert werden, ohne dass es zu unmittelbaren Ausfällen kommt. Jedoch kann sich die Bildqualität oder die erforderliche Messdauer dadurch verändern. Es ist daher von Vorteil, wenn die am Empfang beteiligten Komponenten zumindest vor jeder Bilderfassung in ihrer Empfindlichkeit in der zur Bilderfassung vorgesehenen Konfiguration mit dem Magnetresonanztomographen getestet werden.

Eine Messung der Empfangseigenschaften unter Beteiligung aller Komponenten ist schwierig, da durch Umgebungsparameter wie z.B. geometrische Anordnung der beweglichen Lokalspulen 50 und variable Dämpfung durch den Patienten 100 die Eigenschaften des Empfangsweges mit diesen äußeren Einflüssen gemischt werden.

Es ist daher eine wesentliche Idee der Erfindung, diese zusätzlichen Variablen durch mehrere Messungen zu eliminieren.

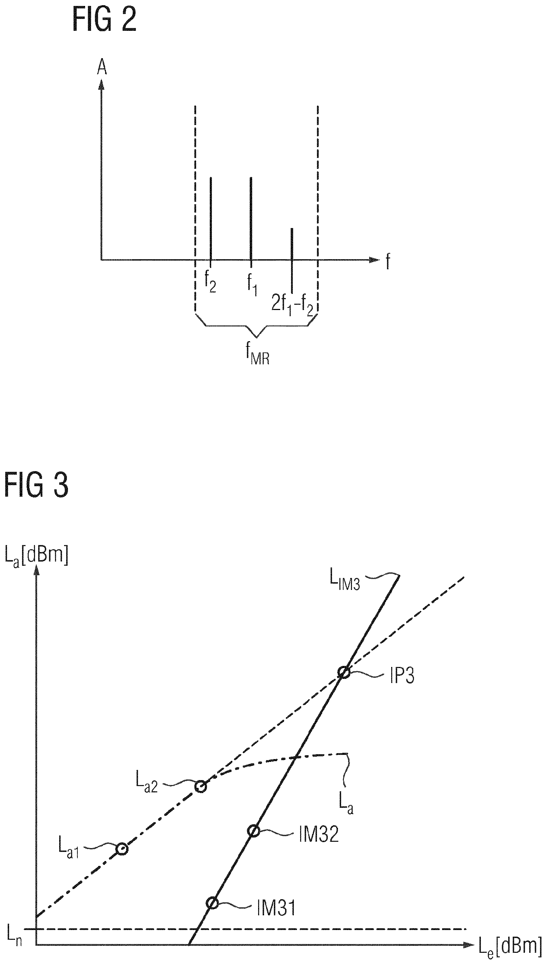

In Fig. 2 sind dabei Frequenzen beispielhaft verwendeter Signale dargestellt. Aufgetragen sind in dem Diagramm die Amplitude A der Signale in beliebigen Einheiten gegenüber der Frequenz f der Signale. Es ist dabei von besonderem Vorteil, wenn alle verwendeten Signale in einen Frequenzbereich f_{MR} fallen, der auch einem Empfangsbereich des Empfängers 65 entspricht. Dieser Empfangsbereich ist üblicherweise um die Larmorfrequenz angeordnet, die durch das statische Magnetfeld B0 und die zu untersuchenden Kernspins definiert ist. Eine typische Bandbreite ist kleiner als 100 kHz, 500 kHz oder 1 MHz.

Dies kann beispielsweise erreicht werden, indem zwei nahe beieinanderliegende Frequenzen f1 und f2 in dem Frequenzbereich f_{MR} ausgewählt werden. Ein Intermodulationsprodukt ungerader Ordnung kann dann nahe der beiden erzeugenden Frequenzen f1 und f2 liegen. Beispielsweise liegt eine Frequenz des Intermodulationsproduktes 3. Ordnung (IM3) gemäß der Formel f_{IM3} = 2f₁-f₂ wie dargestellt um die Frequenzdifferenz nach oben verschoben neben den Frequenzen f₁ und f₂. Vorzugsweise weist das vom Prüfsender 60 selbst erzeugte Signal dabei selbst keinen oder nur einen vernachlässigbaren Anteil eines IM3 Signals auf, beispielsweise mit einer Dämpfung von 20 dB, 40 dB, 60 dB oder mehr. So lässt sich das IM3-Signal im Empfänger dem Empfangsweg zuordnen und leichter auswerten, da nicht eine Änderung, sondern im Wesentlichen der Betrag in der Analyse betrachtet werden kann.

Fig. 3 zeigt dazu schematisch in einem Diagramm eine ausführungsform eines Verfahrens zur Bewertung der Empfangskette. Horizontal ist ein Eingangspegel in logarithmischer Skala aufgetragen. Dieser kann dem Pegel eines der beiden Eingangssignale des Zweitonsignals mit den Frequenzen f₁ und f2 entsprechen oder aus beiden abgeleitet sein. Vorzugsweise sind die Pegel gleich oder in einem festen Verhältnis zueinander, um die Auswertung zu erleichtern. In dem Diagramm kann dann der Eingangspegel durch einen einzelnen Wert auf der horizontalen Achse repräsentiert sein.

Zu jedem Eingangspegel werden die entsprechenden Ausgangspegel Lₐ gemessen. Dabei lassen sich die Ausgangspegel der durch die lineare Verstärkung aus dem Zweitonsignal mit f₁ und f₂ erzeugten Ausgangssignale und dem durch nichtlineare Verstärkung erzeugten Intermodulationsproduktes höherer Ordnung (hier IM3) anhand der Frequenz durch Filter oder eine Fouriertransformation trennen und die Pegel für jede Frequenz separat bestimmen. Auf diese Weise erhält man zu jedem Eingangssignal Lₑ mindestens zwei Ausgangswerte, im Diagramm Lₐₓ bzw. IM3ₓ, die als Punkte im Koordinatensystem angetragen sind. Vorzugsweise ist dabei der Eingangspegel Le so gewählt, dass die Ausgangspegel La bzw. IM3 über einem Rauschpegel Lₙ der Empfangsschleife liegen. Für zwei unterschiedliche Eingangspegel erhält man auf diese Weise insgesamt 4 Punkte.

Da die Verstärkung in der Empfangsschleife in erster Näherung linear ist, wird so durch die Punkte Lₐ₁ und Lₐ₂ und einer Geraden durch diese Punkte eine Kennlinie der Verstärkung der gesamten Empfangsschleife definiert. Dies knickt durch Kompression am oberen Ende des Linearbereichs in eine Horizontale, bei der durch Sättigung der Ausgangspegel unabhängig von dem Eingangssignalpegel ist. Vorzugsweise werden dabei die Eingangspegel Lₑ so gewählt, dass die Ausgangspegel unterhalb dieses Knicks im Linearbereich der Empfangsschleife liegen. Auch ist es denkbar, eine Vielzahl an Eingangspegel Lₑ zu verwenden und dazugehörigen Ausgangspegel Lₐ bzw. IM3 zu messen und daraus nur die Wertepaare zu wählen, die im Linearbereich und über dem Rauschpegel liegen.

Auch die Intermodulationsprodukte steigen mit dem Eingangspegel an, aufgrund der höheren Ordnung jedoch auch mit höherem Exponenten, bei IM3 um den Faktor 3 steiler. Durch zwei Punkte IM3₁ und IM3₂ ist auch hier eine Gerade festgelegt. Aufgrund der unterschiedlichen Steigungen schneiden Sich die Geraden für die Linearanteile Lₐ und die IM3 in einem Punkt, der als Schnittpunkt 3. Ordnung (Intercept Point 3, IP3) bezeichnet wird. Auch wenn dieser Punkt wegen der einsetzenden Kompression nicht real messbar ist, ist er doch charakteristisch für die Verstärkungseigenschaften der Empfangsschleife. Insbesondere ist er unempfindlich gegen parallele Verschiebung in der Abszisse, wie sie beispielsweise durch unterschiedliche Einkopplungsdämpfung des Zweitonsignals durch Veränderung der Lage einer Lokalspule 50 verursacht wird, denn beide Geraden werden um den gleichen Wert in der Abszisse verschoben, sodass sich diese Änderung bei der Bestimmung des Schnittpunktes wieder aufhebt.

Das Prinzip der Erfindung ist hier nicht auf den IP3 beschränkt. Beispielsweise können auch Schnittpunkte höherer, ungerader Ordnung wie IP5 oder IP7 genutzt werden. Auch sind eine Vielzahl mathematisch äquivalente Berechnungen im Rahmen des erfindungsgemäßen Verfahrens denkbar, die mittels Verwendung mehrerer Messpunkte für lineares Ausgangssignal und Intermodulationsprodukt variable Faktoren des Verfahrens wie die Kopplungsstärke eliminieren. Die in Fig. 3 dargestellte Ausführungsform wurde hierbei insbesondere wegen ihrer Anschaulichkeit im Diagramm gewählt.

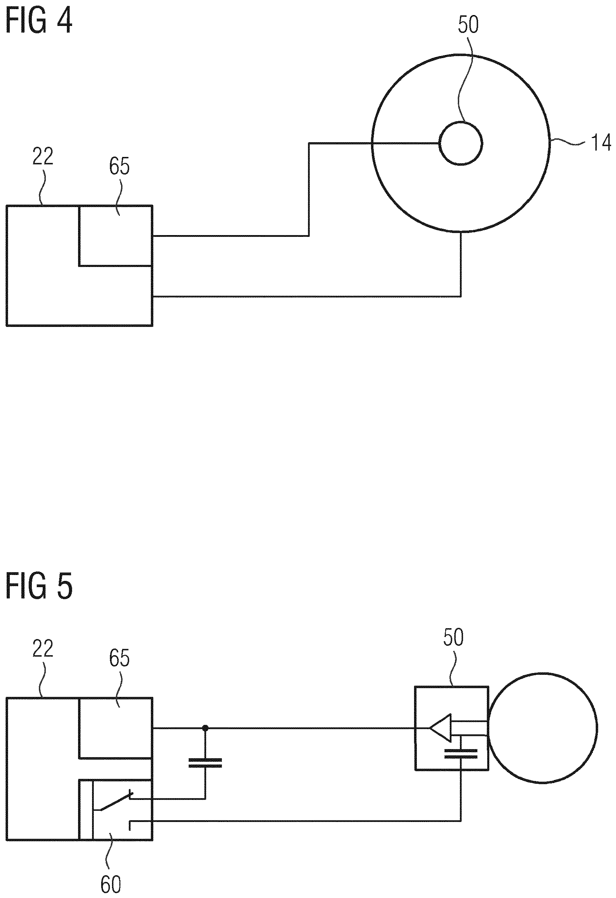

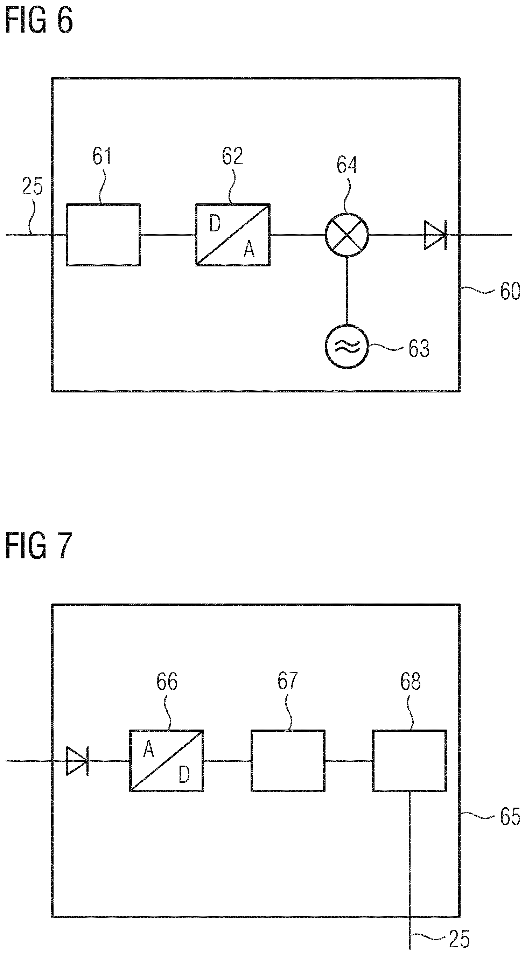

In Fig. 4 ist eine Ausführungsform der für das erfindungsgemäße Verfahren benutzten Komponenten eines Magnetresonanztomographen 1 dargestellt. Dabei erzeugt die Hochfrequenzeinheit 22 das Zweitonsignal mit den Frequenzen f₁ und f₂ und sendet diese über die Körperspule 14 aus. Grundsätzlich ist die Hochfrequenzeinheit 22 ja ausgelegt, Signale mit einer Frequenz um die Larmorfrequenz herum zur Anregung der Kernspins zu erzeugen. Es ist dabei erforderlich, dass die Hochfrequenzeinheit 22 ausgelegt ist, auch Signale mit ausreichend geringer Amplitude und genügender Linearität zu erzeugen, sodass diese nicht den Empfänger 65 nicht übersteuern bzw. in die Kompression fahren und gleichzeitig nicht selbst bereits ein IM3-Signal mit nennenswerter Amplitude erzeugt. Details zu dem Sendeteil bzw. dem Prüfsender 60 werden zu Fig. 6 näher erläutert.

In die Empfangsschleife wird das Zweitonsignal über die Lokalspule 50 bzw. deren Antennenspule induktiv eingekoppelt. Auf diese Weise können alle am Empfang beteiligten Komponenten des Empfangspfades über die Antennenspule und LNB der Lokalspule 50, Signalverbindungen, Stecker, Schaltmatrix bis hin zu dem Empfänger 65 geprüft werden. Beispielsweise kann die Steuerung 23 des Magnetresonanztomographen 1 die Erzeugung des Zweitonsignals durch die Hochfrequenzeinheit 22 und die Auswertung des mit dem Empfänger 65 empfangenen Signals gemäß dem erfindungsgemäßen Verfahren steuern.

In Fig. 5 wird beispielhaft eine andere Ausführungsform des Magnetresonanztomographen dargestellt. Hierbei weist der Prüfsender 60 einen Schalter bzw. eine Schaltmatrix auf, mit der das Zweitonsignal wahlweise an unterschiedlichen Stellen in die Empfangsschleife eingekoppelt werden kann. Beispielhaft sind hier zwei Einspeisepunkte mit kapazitiver Kopplung angegeben. Ein Einspeisepunkt ist am Eingang des LNB in der Lokalspule 50, der andere am Eingang zu dem Empfänger 65. Auf diese Weise ist es auf vorteilhafte Weise möglich, das erfindungsgemäße Verfahren für beide Einspeisepunkte nacheinander auszuführen und so ein mögliches Problem in der Lokalspule 50 zu lokalisieren bzw. auszuschließen. Durch die direkte Einkopplung lassen sich auch unterschiedliche Kopplung durch geometrische Faktoren ausschließen.

Der Prüfsender 60 kann dabei der gleiche Sender sein, der auch zur Anregung der Kernspins genutzt wird, nur Teile davon wie eine Sendesignalaufbereitung ohne Leistungsendstufe, oder auch ein dedizierter Prüfsender mit unabhängiger Signalerzeugung. Ein separater Prüfsender 60 lässt sich besonders einfach in Hinsicht auf die Linearität optimieren.

In Fig. 6 ist schematisch eine mögliche Ausführungsform für einen Prüfsender 60 dargestellt, wie sie sowohl als integrierter Sender zur Anregung der Kernspins (zumindest in der Signalaufbereitung) oder auch als dedizierter Prüfsender 60 denkbar ist. Dabei weist der Prüfsender 60 einen Sendespeicher 61 auf, in den die Steuerung 23 über den Signalbus 25 ein Sendesignal schreiben kann. Dies kann beispielsweise eine Hüllkurve oder explizit ein Signal in einem Basisband in Form einer Folge von realen oder komplexen Amplitudenwerten sei. Das Signal wird von einem D/A-Wandler 62 ausgelesen und in ein analoges Signal gewandelt. Durch Mischung mit einer von einem Oszillator 63 erzeugten Zwischenfrequenz in einem Mischer 64 wird das Signal in den gewünschten Frequenzbereich f_{MR} um die Larmorfrequenz umgesetzt.

Die digitale Bereitstellung des Basisbandsignals erlaubt dabei beliebige Frequenz- und Amplitudenverteilung, insbesondere auch die Erzeugung des Basisbandsignals. Darüber hinaus ist aber auch die gezielte Anregung von einzelnen Schichten bei einer MR-Bilderfassung denkbar. Bei dieser Ausführungsform unterscheidet sich das Prüfsignal von einem Anregungssignal für die Kernspins im Wesentlichen durch die nachfolgende Verstärkung. Während für das erfindungsgemäße Verfahren je nach Kopplung Signale mit einigen Mikrowatt bis Milliwatt bei hoher Linearität erforderlich sind, muss eine Endstufe zur Anregung hunderte Watt bis Kilowatt an Leistung bereitstellen. Der Prüfsender 60 kann deshalb auch durch einen Teil eines Senders zur Kernspinanregung ohne oder mit spezielle Kleinleistungsendstufe bereitgestellt werden

Grundsätzlich denkbar wäre als reiner Prüfsender aber auch eine einfache Kombination aus zwei Oszillatoren, einem Summierglied und einer einstellbaren Verstärkung.

In Fig. 7 ist ein Empfänger 65 dargestellt, wie er auch zum Empfang der MR-Signale genutzt wird. Das eingehende analoge Signal wird verstärkt und gegebenenfalls gefiltert. Denkbar ist auch eine Umsetzung auf eine Zwischenfrequenz bzw. Basisband, die in dem Empfänger erfolgen kann oder auch in einer vorhergehenden Stufe wie der Lokalspule 50. Das analoge Signal wird von einem A/D-Wandler 66 digitalisiert, von einem Signalprozessor 67 oder einem FPGA digital weiterverarbeitet und in digitalisierter Firm in einem Empfangsspeicher 68 der Steuerung 23 bereitgestellt, die über den Signalbus 25 darauf zugreifen kann. Die Trennung der Frequenzen f₁, f₂ und des IM3 sowie die Bewertung der Pegel kann dabei beispielsweise bereits in dem Signalprozessor 67 erfolgen oder erst durch die Steuerung 23.

Bei der Auswertung wird dabei auch eine mögliche analoge oder digitale Frequenzumsetzung berücksichtigt, durch die die Frequenzen f₁, f₂ und die des IM3 in das Basisband umgesetzt werden.

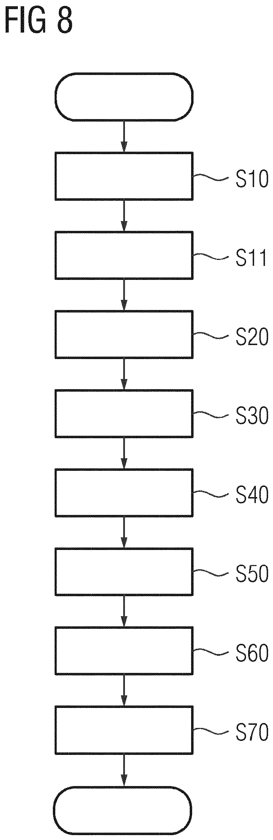

In Fig. 8 ist schematisch ein Ablaufdiagramm einer Ausführungsform des erfindungsgemäßen Verfahrens dargestellt.

In einem Schritt S10 gibt der Prüfsender ein ersten Zweitonsignals aus. Die Eigenschaften des Prüfsenders und des Zweitonsignals wurden bereits zu den voranstehenden Figuren ausführlich erläutert. Das Aussenden kann über eine Antenne bzw. erfolgen oder auch direkt durch eine elektrische Signalverbindung in den Empfangspfad. Das Prüfsignal wird über die auf diese Weise bereitgestellte Signalschleife von dem Prüfsender 60 bis zu Analyseeinrichtung, vorzugsweise dem Empfänger 65, zum Erfassen geleitet.

Denkbar ist es auch, dass dabei in einem Schritt S11 die Signalweiche, beispielsweise ein Schaltmatrix, eingestellt wird, um das Prüfsignal über die Schaltmatrix an einem vorbestimmten Punkt einzuspeisen und so die Signalschleife zu schlie-βen. Durch Wiederholen des Verfahrens mit verschiedenen Einstellungen der Signalweiche und damit verbundenen Einspeisepunkten kann so ein Fehler im Empfangspfad näher lokalisiert werden.

In einem weiteren Schritt erfasste die Analyseeinrichtung ein erstes Prüfsignal mit einem ersten Intermodulationsprodukt über die Signalschleife. Als Erfassen wird dabei zumindest verstanden, dass eine Amplitude des Zweitonsignals, d.h. einer oder beider Tonsignale, und des Intermodulationssignals in dem empfangenen Prüfsignal ermittelt wird. Erfassen kann aber auch das Digitalisieren des ersten Prüfsignals und optional speichern umfassen, sodass die nachfolgende Auswertung mit digitalen Signalverarbeitungsvorgängen, wie z.B. Filter oder FFT, erfolgt.

In einem weiteren Schritt S30 gibt der Prüfsender eine zweites Zweitonsignals mit einem zweiten Pegel durch den Sender aus. Dabei unterscheidet sich das erste Zweitonsignal zumindest im Pegel von dem ersten Zweitonsignal. Vorzugsweise bleiben die Frequenzen und das Amplitudenverhältnis unverändert, es ist aber auch denkbar, diese auf vorbestimmte und damit in der Auswertung nachvollziehbare Weise zu verändern.

In einem weiteren Schritt S40 erfasst die Analyseeinrichtung eine zweites Prüfsignal mit dem zweiten Zweitonsignal und einem zweiten Intermodulationsproduktes über die Signalschleife Hier gilt das zu Schritt S20 ausgeführte.

In einem Schritt S50 ermittelt die Analyseeinrichtung einen Prüfwerte in Abhängigkeit von dem Pegel des ersten Zweitonsignals, dem Pegel des zweiten Zweitonsignals, einem Pegel des ersten Intermodulationsproduktes und einem Pegel des zweiten Intermodulationsproduktes. Der Prüfwert kann der in der zu Fig. 3 dargestellt Output Intercept Point 3 OIP3 sein, aber auch andere mathematisch durch äquivalente Umformungen erzielbare Prüfwerte oder Prüfwerte, bei denen eine variable Kopplung zwischen Prüfsender 60 und Analyseeinrichtung eliminiert ist.

In einem Schritt S60 vergleicht die Analyseeinrichtung den Prüfwerte mit einem Referenzwert. Beispielsweise kann die Analyseeinrichtung feststellen, ob der Prüfwert unterhalb oder oberhalb eines Grenzwertes liegt oder innerhalb oder außerhalb eines Fensters bzw. Wertebereiches.

Die Analyseeinrichtung gibt in einem weiteren Schritt S70 ein Signal an eine Steuerung 23 des Magnetresonanztomographen 1 oder eine Anzeige für eine Bedienperson in Abhängigkeit von dem Ergebnis des Vergleichs aus. Beispielsweise kann ein Hinweis ausgegeben werden, dass der Empfangspfad degradiert ist, wenn der Wert für den OIP3 unter einen Schwellwert abgesunken ist.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen, welcher durch die Ansprüche definiert ist.

## Patentansprüche

1. Verfahren zur Funktionsprüfung einer Empfangskette eines Magnetresonanztomographen (1), wobei der Magnetresonanztomograph (1) einen Empfänger (65) und einen Sender aufweist, wobei der Sender ausgelegt ist, ein erstes Zweitonsignal mit einer ersten Frequenz f1 und einer zweiten Frequenz f2 und einem Pegel p zu erzeugen und auszugeben, wobei die erste Frequenz f1, die zweite Frequenz f2 und ein Intermodulationsprodukt ungerader Ordnung oder höherer Ordnung der ersten Frequenz f1 und der zweiten Frequenz f2 in einem Empfangsbereich des Empfängers (65) liegen, wobei die erste Frequenz f1 ungleich der zweiten Frequenz f2 ist,
und ein Pegel des ausgesendeten Zweitonsignals in einem Pegelbereich liegt, bei dem das empfangene Zweitonsignal am Empfänger (65) in einem Linearbereich des Empfängers (65) liegt und das Intermodulationsprodukt ungerader Ordnung über einem Rauschpegel des Empfängers (65),
wobei der Sender ausgelegt ist, ein zweites Zweitonsignal auszusenden, das sich im Pegel von dem ersten Zweitonsignal unterscheidet,
wobei der Magnetresonanztomograph (1) eine Analyseeinrichtung aufweist, die ausgelegt ist, einen Pegel des Intermodulationsproduktes in einem Eingangssignal des Empfängers (65) zu bestimmen,
wobei der Magnetresonanztomograph eine Signalschleife aufweist, die ausgelegt ist, das erste und das zweite Zweitonsignal des Senders in eine Komponente eines Empfangsweges des Empfängers einzukoppeln,
wobei das Verfahren die Schritte aufweist:
(S10) Ausgeben eines ersten Zweitonsignals mit einem ersten Pegel durch den Sender;
(S20) Erfassen eines ersten Prüfsignals mit einem ersten Intermodulationsprodukt über die Signalschleife durch die Analyseeinrichtung;
(S30) Ausgeben eines zweiten Zweitonsignals mit einem zweiten Pegel durch den Sender, wobei sich das erste Zweitonsignal im Pegel von dem ersten Zweitonsignal unterscheidet;
(S40) Erfassen eines zweiten Prüfsignals mit einem zweiten Intermodulationsprodukt über die Signalschleife durch die Analyseeinrichtung;
(S50) Ermitteln eines Prüfwertes in Abhängigkeit von dem Pegel des ersten Zweitonsignals, dem Pegel des zweiten Zweitonsignals, einem Pegel des ersten Intermodulationsproduktes und einem Pegel des zweiten Intermodulationsproduktes;
(S60) Vergleichen des Prüfwertes mit einem Referenzwert durch die Analyseeinrichtung;
(S70) Ausgeben eines Signals an eine Steuerung (23) des Magnetresonanztomographen oder eine Anzeige für eine Bedienperson in Abhängigkeit von dem Vergleich.

2. Verfahren nach Anspruch 1, wobei der Schritt (S50) des Ermittelns eines Prüfwertes das Bestimmen eines OIP3 umfasst.

3. Verfahren nach Anspruch 1, wobei der Magnetresonanztomograph (1) eine Signalweiche im Signalpfad der Zweitonsignale aufweist und eine Steuerung (23) des Magnetresonanztomographen (1) ausgelegt ist, die Zweitonsignale des Senders mittels der Signalweiche in unterschiedliche Komponenten des Empfangsweges einzukoppeln, wobei vor dem Schritt (S10) des Ausgebens des ersten Zweitonsignals ein Schritt (S11) des Einstellens der Signalweiche zur Bereitstellung der Signalschleife durchgeführt wird.

## Claims

1. Method for functional testing of a receive chain of a magnetic resonance tomography scanner (1), wherein the magnetic resonance tomography scanner (1) has a receiver (65) and a transmitter, wherein the transmitter is designed to generate and output a first two-tone signal with a first frequency f1 and a second frequency f2 and a level p, wherein the first frequency f1, the second frequency f2 and an odd-order or higher-order intermodulation product of the first frequency f1 and the second frequency f2 lie in a receiving range of the receiver (65), wherein the first frequency f1 is not equal to the second frequency f2,
and a level of the transmitted two-tone signal lies in a level range in which the received two-tone signal at the receiver (65) lies in a linear range of the receiver (65) and the odd-order intermodulation product lies above a noise level of the receiver (65),
wherein the transmitter is designed to transmit a second two-tone signal, which differs from the first two-tone signal in level,
wherein the magnetic resonance tomography scanner (1) has an analysis facility, which is designed to determine a level of the intermodulation product in an input signal of the receiver (65),
wherein the magnetic resonance tomography scanner (1) has a signal loop, which is designed to couple the first and the second two-tone signal of the transmitter into a component of a receive path of the receiver,
wherein the method has the steps:
(S10) Outputting a first two-tone signal at a first level by way of the transmitter;
(S20) Acquiring a first test signal with a first intermodulation product via the signal loop by way of the analysis facility;
(S30) Outputting a second two-tone signal at a second level by way of the transmitter, wherein the first two-tone signal differs from the first two-tone signal in level;
(S40) Acquiring a second test signal with a second intermodulation product via the signal loop by way of the analysis facility;
(S50) Ascertaining a test value as a function of the level of the first two-tone signal, the level of the second two-tone signal, a level of the first intermodulation product and a level of the second intermodulation product;
(S60) Comparing the test value with a reference value by way of the analysis facility;
(S70) Outputting a signal to a controller (23) of the magnetic resonance tomography scanner or a display for an operator, as a function of the comparison.

2. Method according to claim 1, wherein the step (S50) of ascertaining a test value comprises the determination of an OIP3.

3. Method according to claim 1, wherein the magnetic resonance tomography scanner (1) has a signal splitter in the signal path of the two-tone signals and a controller (23) of the magnetic resonance tomography scanner (1) is designed to couple the two-tone signals of the transmitter into different components of the receive path by means of the signal splitter,
wherein a step (S11) of adjusting the signal splitter to provide the signal loop is performed before the step (S10) of outputting the first two-tone signal.

## Revendications

1. Procédé de contrôle du fonctionnement d'une chaîne de réception d'un tomodensitomètre (1) par résonnance magnétique, dans lequel le tomodensitomètre (1) par résonnance magnétique a un récepteur (65) et un émetteur, dans lequel l'émetteur est conçu pour produire et émettre un premier signal à deux tons ayant une première fréquence f1 et une deuxième fréquence f2 et un niveau p, dans lequel la première fréquence f1, la deuxième fréquence f2 et un produit d'intermodulation d'ordre impair ou d'ordre supérieur de la première fréquence f1 et de la deuxième fréquence f2 sont dans un domaine de réception du récepteur (65), dans lequel la première fréquence f1 n'est pas égale à la deuxième fréquence f2,
et un niveau du signal à deux tons émis est dans un domaine de niveau, dans lequel le signal à deux temps reçu au récepteur (65) est dans un domaine linéaire du récepteur (65) et le produit d'intermodulation d'ordre impair est au-dessus d'un niveau de bruit du récepteur (65),
dans lequel l'émetteur est conçu pour émettre un deuxième signal à deux tons, qui se distingue en niveau du premier signal à deux tons,
dans lequel le tomodensitomètre par résonnance magnétique a un dispositif d'analyse, qui est conçu pour déterminer un niveau du produit d'intermodulation dans un signal d'entrée du récepteur (65),
dans lequel le tomodensitomètre (1) par résonnance magnétique a une boucle de signal, qui est conçue pour injecter le premier et le deuxième signal à deux tons de l'émetteur dans un composant d'un chemin de réception du récepteur,
dans lequel le procédé comporte les stades :
(S10) émission d'un premier signal à deux tons ayant un premier niveau par l'émetteur ;
(S20) détection d'un premier signal de contrôle ayant un premier produit d'intermodulation sur la boucle de signal par le dispositif d'analyse ;
(S30) émission d'un deuxième signal à deux tons ayant un deuxième niveau par l'émetteur, le premier signal à deux tons se distinguant en niveau du premier signal à deux tons ;
(S40) détection d'un deuxième signal de contrôle ayant un deuxième produit d'intermodulation sur la boucle de signal par le dispositif d'analyse ;
(S50) détermination d'une valeur de contrôle en fonction du niveau du premier signal à deux tons, du niveau du deuxième signal à deux tons, d'un niveau du premier produit d'intermodulation et d'un niveau du deuxième produit d'intermodulation ;
(S60) comparaison de la valeur de contrôle à une valeur de référence par le dispositif d'analyse ;
(S70) envoi d'un signal à une commande (23) du tomodensitomètre par résonnance magnétique ou à un affichage pour une personne de service en fonction de la comparaison.

2. Procédé suivant la revendication 1, dans lequel le stade (S50) de la détermination d'une valeur de contrôle comprend la détermination d'un OIP3.

3. Procédé suivant la revendication 1, dans lequel le tomodensitomètre (1) par résonnance magnétique a une bifurcation du signal dans le chemin des signaux à deux tons et une commande (23) du tomodensitomètre (1) à résonnance magnétique est conçue pour injecter les signaux à deux tons de l'émetteur au moyen de la bifurcation du signal dans des composants différents du chemin de réception,
dans lequel avant le stade (S10) de l'émission du premier signal à deux tons, on effectue un stade (S11) de réglage de la bifurcation du signal pour la mise à disposition de la boucle de signal.
